# EUROPEAN PATENT APPLICATION

(11) **EP 3 933 503 A1**
(43) Date of publication of application: **05.01.2022**
(21) Application number: 20920048.4
(22) Date of filing: 20.11.2020
(51) Int. Cl.: G03F 1/26

(54) **MASK PATTERN APPLIED TO SEMICONDUCTOR PHOTOLITHOGRAPHY PROCESS AND METHOD FOR PHOTOLITHOGRAPHY PROCESS**

(30) Priority: 22.02.2020 CN 202010109640
(71) Applicant: Changxin Memory Technologies, Inc., Hefei, Anhui 230601 (CN)
(72) Inventor: FAN, Congcong, Hefei, Anhui 230601 (CN)
(74) Representative: Lavoix
(86) International application number: PCT/CN2020/130386
(87) International publication number: WO 2021/164354

(57) **Abstract**

The present disclosure provides a mask pattern for a semiconductor photolithography process and a semiconductor photolithography process. The mask pattern comprises: a pattern, the pattern comprising a light-transmitting area and a light-shielding area which are alternately arranged, the pattern having a boundary formed by an end portion of the light-transmitting area and an end portion of the light-shielding area, and an edge light-transmitting area being formed at the boundary. By the mask pattern of the present disclosure, a pattern with smooth edges can be formed on a wafer, and the edge roughness of the pattern is low, which meets the design requirements, thereby improving product quality and yield.

## Description

### CROSS-REFERENCE TO RELATED APPLICATIONS

The present disclosure claims the priority to the Chinese patent application 202010109640.1, titled "MASK PATTERN FOR SEMICONDUCTOR PHOTOLITHOGRAPHY PROCESSES AND METHOD FOR PHOTOLITHOGRAPHY PROCESSES", and filed on February 22, 2020, the entire contents of which are incorporated herein by reference.

### TECHNICAL FIELD

The present disclosure relates to the field of semiconductor manufacturing, in particular to a mask pattern for a semiconductor photolithography process and a photolithography process.

### BACKGROUND

With the development of the semiconductor manufacturing process, the area of the semiconductor chip is getting smaller and smaller. Therefore, the accuracy of the semiconductor process has become more important. In the semiconductor manufacturing process, an important process step is the photolithography process. The photolithography process is mainly to transfer a mask pattern on a reticle to the wafer, after which other subsequent processes can be carried out to complete the fabrication of the entire semiconductor device. Therefore, the quality of the photolithography process will directly affect the performance of the resulting semiconductor device.

In the prior art, after the patterns on the reticle are transferred to the wafer, the edges of these patterns on the wafer are rough. For example, alignment marks are formed by transferring the patterns on the reticle to the wafer in the semiconductor process, if the edge roughness of these alignment marks is large, the overlap accuracy of subsequent patterns may be affected and thus reduce product quality and yield.

Therefore, how to effectively improve the roughness of the pattern formed by transferring the pattern on the reticle to the wafer is a problem to solved urgently.

### SUMMARY

The technical problem to be solved in the present disclosure is to provide a mask pattern for a semiconductor lithography process and a lithography process, by which a pattern with smooth edges can be formed on a wafer and the edge roughness of the pattern can be reduced.

In order to solve the above-mentioned problem, the present disclosure provides a mask pattern for a semiconductor photolithography process, comprising: a pattern, the pattern comprising a light-transmitting area and a light-shielding area which are alternately arranged, the pattern having a boundary formed by an end portion of the light-transmitting area and an end portion of the light-shielding area, and an edge light-transmitting area being formed at the boundary.

In some embodiments, the edge light-transmitting area extends along an inner side of the boundary.

In some embodiments, both ends of the edge light-transmitting area are connected to the light-transmitting areas located at both ends of the boundary.

In some embodiments, the edge light-transmitting area communicates with the light-transmitting area extending to the boundary.

In some embodiments, the outer side of the edge light-transmitting area is a boundary line of the pattern at the boundary.

In some embodiments, the light-transmitting area and the edge light-transmitting area have a same transmittance.

In some embodiments, light-transmitting area and the light-shielding area are in different planes.

In some embodiments, the light-shielding area has a transmittance of 6% or 30%.

In some embodiments, the pattern is an alignment mark.

The present disclosure further provides a photolithography process method, wherein the mask pattern described above is used.

The present disclosure has the following advantages: by the arrangement of the edge light-transmitting area at the boundary, the difference in transmittance between the light-transmitting area and the light-shielding area is reduced, the transmittance is uniformly distributed, and the energy of light incident onto corresponding areas on the wafer from the edge light-transmitting area is uniformly distributed, so that a pattern with smooth edges can be formed on the wafer, and the edge roughness of the pattern is low, which meets the design requirements, thereby improving product quality and yield.

### BRIEF DESCRIPTION OF THE DRAWINGS

FIG. 1 is a schematic diagram of an existing mask pattern and the final pattern formed by transferring it to a wafer, where (a) is the mask pattern and (b) is the pattern formed on the wafer;
FIG. 2 is a schematic structure diagram of a first specific implementation of a mask pattern for a semiconductor photolithography process according to the present disclosure, where (a) is the mask pattern, and (b) is the pattern formed on the wafer; and
FIG. 3 is a schematic structure diagram of a second specific implementation of a mask pattern for a semiconductor photolithography process according to the present disclosure, where (a) is the mask pattern, and (b) is the pattern formed on the wafer.

### DESCRIPTION OF THE EMBODIMENTS

The specific implementations of a mask pattern for a semiconductor photolithography process and a photolithography process according to the present disclosure will be described in detail below with reference to the accompanying drawings. In order to clearly describe the technical solution, the structures in the drawings are appropriately enlarged.

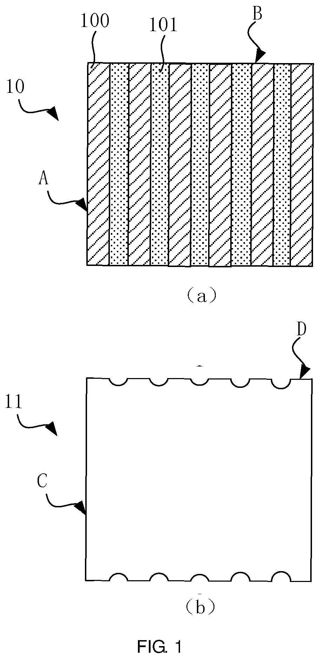

FIG. 1 is a schematic diagram of an mask pattern and the final pattern formed by transferring it to a wafer, where (a) is the mask pattern and (b) is the pattern formed on the wafer. Referring to FIG. 1, the mask pattern 10 comprises a light-transmitting area 100 and a light-shielding area 101 which are alternately arranged. The mask pattern 10 is transferred to a wafer, to form a pattern 11 on the wafer.

There are two kinds of boundary of the mask pattern 10: a boundary formed by a side of the light-transmitting area (boundary indicated by arrow A in FIG. 1), and a boundary formed by the alternate arrangement of ends of the light-transmitting area 100 and ends of the light-shielding area 101 (boundary indicated by arrow B in FIG. 1). It was found that the boundary (boundary indicated by arrow C in FIG. 1) of the pattern 11 on the wafer, which is formed by transferring the pattern boundary indicated by the arrow A in the mask pattern 10 to the wafer, is smooth, and the roughness meets the requirements. While the boundary (boundary indicated by arrow D in FIG. 1) of the pattern 11 on the wafer, which is formed by transferring the pattern boundary indicated by the arrow B in the mask pattern 10 to the wafer, is not smooth, with high roughness, which affects the performance of the semiconductor device.

It was found that the reason for the above phenomenon is that, at the boundary formed by the alternate arrangement of ends of the light-transmitting area 100 and ends of the light-shielding area 101, there is a difference in transmittance between the light-transmitting area 100 and the light-shielding area 101. As a result, during the exposure process, the energy distribution of light at the boundary is uneven. Consequently, at corresponding boundary of the pattern 11 on the wafer, the pattern edge of areas corresponding to the light-transmitting area 100 extends outward, while the pattern edge of areas corresponding to the light-shielding area 101 contracts inward, resulting in non-smooth boundary with high roughness.

In view of the above-mentioned reason, the present disclosure provides a mask pattern which can overcome the above-mentioned defects, thereby obtaining a pattern with a required edge roughness on a wafer.

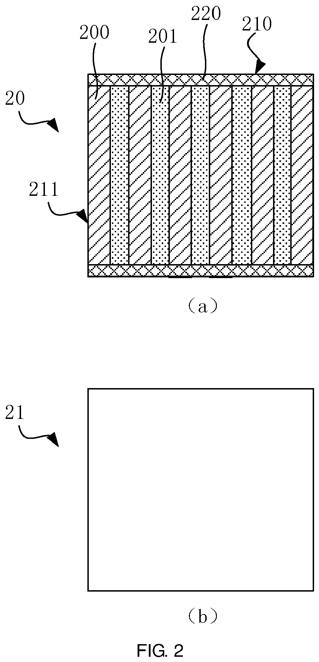

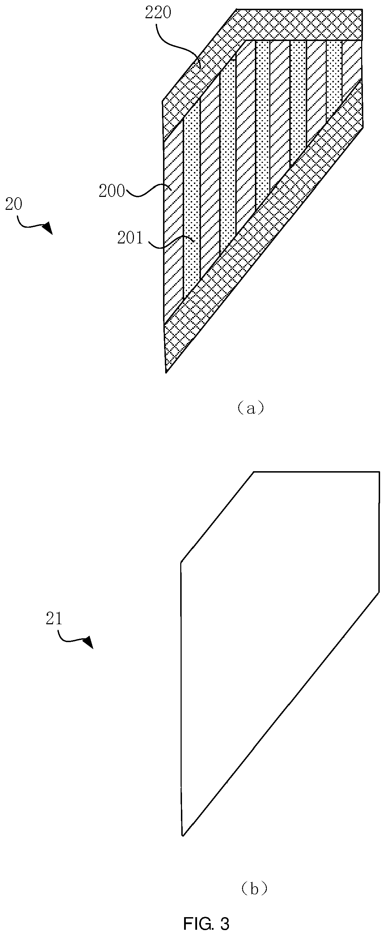

FIG. 2 is a schematic structure diagram of a first specific embodiment of a mask pattern for a semiconductor photolithography process according to the present disclosure, where (a) is the mask pattern, and (b) is the pattern formed on the wafer. Please refer to FIG. 2, the mask pattern comprises at least one pattern 20. The pattern 20 can form an independent pattern 21 with a same shape on the wafer. For example, if the pattern 20 is a rectangle, it can form a rectangular pattern 21 on the wafer; if the pattern 20 is a triangle, it can form a triangular pattern on the wafer. In this specific implementation, the pattern 20 is a rectangle, and it forms a rectangular pattern on the wafer. In another specific implementation of the present disclosure (please refer to FIG. 3), the pattern 20 is an irregular shape and it forms a same irregular pattern 21 on the wafer.

In this embodiment, only one pattern 20 is schematically shown. In other embodiments of the present disclosure, a plurality of pattern groups 20 may be provided, depending upon the number of patterns that need to be formed on the wafer.

The pattern 20 comprises at least one light-transmitting area 200 and at least one light-shielding area 201 which are alternately arranged. In this embodiment, the pattern 20 comprises a plurality of light-transmitting areas 200 and a plurality of light-shielding areas 201. The pattern 20 has at least one boundary formed by ends of the light-transmitting areas 200 and ends of the light-shielding areas 201. In this embodiment, the pattern 20 is a rectangle and has two boundaries 210 formed by ends of the light-transmitting areas 200 and ends of the light-shielding areas 201, and the two boundaries 210 are arranged opposite to each other. The other two boundaries 211 of the pattern 20 are formed by the outer sides of the light-transmitting areas 200, and the two boundaries 211 are arranged opposite to each other.

At each of the boundaries 210 formed by the ends of the light-transmitting areas 200 and the ends of the light-shielding areas 201, an edge light-transmitting area 220 is formed, which can change the light transmittance of the boundaries 210, so that the transmittance of the areas is evenly distributed. Specifically, the edge light-transmitting areas 220 replace the light-transmitting areas 200 and the light-shielding areas 201 as the new boundaries of the pattern 20. That is, the outer contour of the edge light-transmitting areas 220 is the contour of the pattern 20 at the boundaries 210. In this way, the transmittance at the boundaries 210 is evenly distributed, and the energy of light incident onto the wafer from the edge light-transmitting areas 220 is uniformly distributed, so that a pattern 21 with smooth edges can be formed on the wafer, and the edge roughness of the pattern 21 is low, which meets the design requirements, thereby improving product quality and yield.

In the present disclosure, by the arrangement of the edge light-transmitting areas 220 at the boundaries 210, the difference in transmittance between the light-transmitting areas 200 and the light-shielding areas 201 is reduced, the transmittance is uniformly distributed, and the energy of light incident onto corresponding areas on the wafer from the edge light-transmitting areas 220 is uniformly distributed, so that a pattern with smooth edges can be formed on the wafer.

In other embodiments, both ends of the edge light-transmitting areas 220 are connected to the light-transmitting areas 200 located at both ends of the boundaries 210. Specifically, in this embodiment, both ends of the edge light-transmitting areas 220 are connected to two light-transmitting areas 200 forming the sides of the rectangular shape, so as to outline the complete boundary of the pattern 20.

In other embodiments, the light-transmitting areas 200 and the light-shielding areas 201 are in different planes. Specifically, the mask pattern can be formed on the reticle by deposition or etching. Depending upon different formation methods, the light-transmitting areas 200 may be grooves and the light-shielding areas 201 may be planes on the upper surfaces of the grooves; or, the light-shielding areas 201 may be grooves, and the light-transmitting areas 200 may be planes on the upper surfaces of the grooves. The light-transmitting areas 200 and the light-shielding areas 201 are not in a same plane.

In other embodiments, the light-transmitting areas 200 and the edge light-transmitting areas 220 have a same transmittance, and both can be formed by a same process. For example, the transmittance of both is 100%, and both are formed by a same process. The light-transmitting areas 200 and the edge light-transmitting areas 220 are completely light-transmissive, so as to improve the utilization of light energy. In other embodiments, the light-shielding areas 201 may have a transmittance of 6% or 30%, which are two kinds of masks with different transmittances.

A method for forming the edge light-transmitting area 220 is to replace the light-shielding area 201 with a light-transmitting material at the boundary 210, and the transmittance of the light-transmitting material is greater than that of the light-shielding area 201. The light-transmitting area 200 and the light-transmitting material together form the edge light-transmitting area 220. Further, the edge light-transmitting area 220 communicates with the light-transmitting area 200 extending to the boundary, so as to prevent the pattern 21 formed on the wafer from being deformed.

In other embodiments, the edge light-transmitting area 220 extends along the inner side of the boundary 210, that is, the edge light-transmitting area 220 covers the end of the light-transmitting area 200, and the outer side of the edge light-transmitting area 220 serves as the boundary line of the pattern 20.

In other embodiments, another method for forming the edge light-transmitting area 220 is to remove the light-shielding area 201 at the boundary 210, and cover the light-transmitting area 200 and an area exposed after removing the light-shielding area 201 with a light-transmitting material, to form the edge light-transmitting area 220. Specifically, during the fabrication of the reticle, at the boundary 210, the length of the light-shielding area 201 can be shortened to reserve an area for fabricating the edge light-transmitting area 220, and the light-transmitting material can be covered on the reserved area and its corresponding main light-transmitting area to form the edge light-transmitting area 220. In this embodiment, the edge light-transmitting area 220 extends along the inner side of the boundary 210.

In this embodiment, the width of the edge light-transmitting area 220 depends upon the parameters of the photolithography process, for example, the dose/DOF of the photolithography process.

In other embodiments, the pattern 20 is an alignment mark, and the pattern 21 formed on the wafer is an alignment mark. The alignment mark is used as an alignment pattern in each step of the semiconductor process.

In other embodiments of the present disclosure, the pattern 20 is a regular rectangle. A second implement of the present disclosure is further provided. The second implement is different from the first implement in that the pattern 20 is an irregular pattern. FIG. 3 is a schematic structure diagram of a second implement of a mask pattern for a semiconductor photolithography process by using the present disclosure, where (a) is the mask pattern, and (b) is the pattern formed on the wafer. Please refer to FIG. 3, at each boundary of the pattern 20 formed by ends of the light-transmitting area 200 and ends of the light-shielding area 201, there is an edge light-transmitting area 220, and the shape of the outer contour of the edge light-transmitting area 220 is the same as the contour shape of the pattern 21 to be formed on the wafer from the pattern 20. During the exposure process, by the edge light-transmitting area 220, the energy of light can be evenly distributed at the boundary, so as to avoid the non-smooth edges of the pattern formed on the wafer. Thus, the roughness meets the requirements, and the product quality and yield are improved.

In other embodiments of the present disclosure provides a photolithography process, wherein the reticle described above is used. Specifically, during the photolithography process, the reticle is used as a mask to be placed above the wafer, and light is incident onto the wafer by passing through the reticle from the other side of the reticle. Then, exposure is performed to form an exposure pattern on the wafer.

The edge light-transmitting area can improve the transmittance at the boundary and reduce the too large difference in transmittance between the light-transmitting area and the light-shielding area at the boundary. Thus, the energy of light on wafer areas corresponding to the edge light-transmitting area is uniformly distributed, so that a pattern with smooth edges can be formed on the wafer. The edge roughness of the pattern is low, which meets the design requirements.

The above description is a preferred implementation of the present disclosure, it should be noted that for a person of ordinary skill in the art, various improvements and modifications may be made without departing from the principle of the present disclosure, and those improvements and modifications should also be regarded as falling into the protection scope of the present disclosure.

## Claims

1. A mask pattern for a semiconductor photolithography process, comprising: a pattern, the pattern comprising a light-transmitting area and a light-shielding area which are alternately arranged, the pattern having a boundary formed by an end portion of the light-transmitting area and an end portion of the light-shielding area, and an edge light-transmitting area being formed at the boundary.

2. The mask pattern according to claim 1, wherein the edge light-transmitting area extends along an inner side of the boundary.

3. The mask pattern according to claim 2, wherein both ends of the edge light-transmitting area are connected to the light-transmitting areas located at both ends of the boundary.

4. The mask pattern according to claim 1, wherein the edge light-transmitting area communicates with the light-transmitting area extending to the boundary.

5. The mask pattern according to claim 1, wherein the outer side of the edge light-transmitting area is a boundary line of the pattern at the boundary.

6. The mask pattern according to claim 1, wherein the light-transmitting area and the edge light-transmitting area have a same transmittance.

7. The mask pattern according to claim 1, wherein light-transmitting area and the light-shielding area are in different planes.

8. The mask pattern according to claim 1, wherein the light-shielding area has a transmittance of 6% or 30%.

9. The mask pattern according to claim 1, wherein the pattern is an alignment mark.

10. A photolithography process method, wherein the mask pattern according to any one of claims 1 to 9 is used.
